Europäisches Patentamt

European Patent Office

Office européen des brevets

(11) Veröffentlichungsnummer: **0 630 873 A1**

## (12) EUROPÄISCHE PATENTANMELDUNG

(21) Anmeldenummer: **94109160.5**

(22) Anmeldetag: **15.06.94**

(51) Int. Cl.5: **C04B 35/00**, H01L 39/24

(30) Priorität: **23.06.93 DE 4320829**

(43) Veröffentlichungstag der Anmeldung:
**28.12.94 Patentblatt 94/52**

(84) Benannte Vertragsstaaten:
**AT BE CH DE DK ES FR GB IT LI NL SE**

(71) Anmelder: **HOECHST AKTIENGESELLSCHAFT**
**Brüningstrasse 50**
**D-65929 Frankfurt am Main (DE)**

(72) Erfinder: **Lang, Christoph, Dr.**
**Heimchenweg 82**
**D-65929 Frankfurt (DE)**
Erfinder: **Elschner, Steffen, Dr.**

**Holbeinstrasse 5d**
**D-65527 Niedernhausen (DE)**
Erfinder: **Hettich, Bernhard, Dr.**
**Im Hirtengarten 8**
**D-65817 Eppstein (DE)**
Erfinder: **Aldinger, Fritz, Prof.**
**Heisenbergstrasse 9**
**D-70569 Stuttgart (DE)**
Erfinder: **Majewski, Peter, Dr.**
**Schorndorfer Strasse 54**
**D-73635 Rudersberg (DE)**
Erfinder: **Kaesche, Stefanie**
**Ludwigstrasse 120**
**D-70197 Stuttgart (DE)**

(54) **Verfahren zur Erhöhung der Pinningkraft bei supraleitender Bi-Pb-Sr-Ca-Cu-O Keramik.**

(57) Zur Erhöhung der Pinningkraft von supraleitendem Bi-Pb-Sr-Ca-Cu-O Material wird die Pb2223-Keramik über eine Zeitspanne von 1 bis 60 Minuten unter sauerstoffhaltiger Atmosphäre auf eine Temperatur von vorzugsweise 865 bis 870 °C erhitzt. Dabei werden Ausscheidungen von $(Sr,Ca)_{14}Cu_{24}O_{41-x}$ und Schmelze mit einer Zusammensetzung $Bi_{1.2}Pb_{0.7}Sr_{0.7}Ca_{0.5}CuO_x$ erzeugt.

Fig. 1

Die technische Anwendung keramischer Bi-(Pb)-Sr-Ca-Cu-O Supraleiter, z.B. in Form von Stäben oder Drähten mit Multifilament-Struktur, ist zur Zeit noch stark eingeschränkt, weil die Hochtemperatur-Supraleiter bei 77 K in einem angelegten Magnetfeld bis jetzt nur geringe elektrische Ströme transportieren können. Dieser Effekt ist auf die Flußsprünge und das Flußkriechen der sogenannten magnetischen Flußschläuche in diesen Materialien zurückzuführen. Für eine technische Anwendung supraleitender Keramiken in einem Magnetfeld ist es daher notwendig, das Flußspringen und -kriechen durch geeignete Stabilisierungsmaßnahmen (Pinning) weitgehend einzuschränken bzw. ganz zu verhindern. Eine Erhöhung der kritischen Stromdichten im Magnetfeld um ein Vielfaches kann durch das Einbringen von Pinning-Zentren in keramischen Supraleitern erreicht werden. Gezielt eingebaute Defekte wie z.B. normalleitende Cluster, Ausscheidungen und Sekundärphasen-Präzipitate in dem supraleitenden Material stellen geeignete Pinning-Zentren dar.

Im Anwendungsfall wird ein solcher Supraleiter bei der Temperatur $T < T_c$ und einem äußeren Magnetfeld $H_{c1} < H_a < H_{c2}$ betrieben. Prinzipiell liegt in diesem Zustand ein Material vor, in dem zwei physikalische Zustände existieren, nämlich einerseits die supraleitende Matrix, die den Suprastrom trägt, und andererseits normalleitende Bereiche, durch die die magnetischen Feldlinien des äußeren Magnetfeldes verlaufen. Die supraleitende Matrix ist durchsetzt von diesen normalleitenden Bereichen, deren Anzahl mit der magnetischen Feldstärke zunimmt. Die normalleitenden Bereiche werden infolge der klassischen Lorenzkraft ($I_{supra}^* H_{außen} = F_{lorenz}$) durch die supraleitende Matrix bewegt. Diese Bewegung verbraucht Energie, welche dem Suprastrom entzogen wird. Die sogenannten Pinning-Zentren stellen energetische Potentialsenken für diese sich bewegenden "Flußschläuche" dar. Die Höhe der Potentialsenken hängt von ihrer Natur, aber auch von der Betriebstemperatur des Supraleiters und der Feldstärke des Magnetfeldes ab.

Die Grundlage für die Entwicklung eines Verfahrens zur Erhöhung der Pinning-Eigenschaften keramischer Bi-Pb-Sr-Ca-Cu-O Supraleiter ist die Kenntnis der Phasengleichgewichte im System $Bi_2O_3$-PbO-SrO-CaO-CuO, speziell der temperaturabhängigen Pb-Löslichkeit der supraleitenden Verbindung

$$(Bi,Pb)_{2+x}(Sr,Ca)_4 Cu_3 O_{10+d} \text{ (Pb2223, Tc = 110K)}.$$

Es wurde nun gefunden, daß sich in diesem System durch die Wahl geeigneter Ausgangszusammensetzungen und Glühtemperaturen gezielt Sekundärphasenpräzipitate in nahezu phasenreinen Keramiken der Pb-haltigen 2223-Phase erzeugen lassen. Die so erzeugten Teilchen erhöhen die Pinning-Eigenschaften des Materials.

Gegenstand der Erfindung zur Erhöhung der Pinningkraft von supraleitenden Bi-Pb-Sr-Ca-Cu-O Keramiken ist die gezielte Entmischung von Pb aus der Pb2223 Phase, während sich die Phasenbeziehungen innerhalb der Proben ändern. Bei 840 °C an Luft besteht die Probe aus Pb2223 Phase und einem Restgehalt an $Ca_2CuO_3$. Bei 850 °C und 865 °C an Luft treten zudem noch $(Sr,Ca)_{14}Cu_{24}O_{41-x}$ und Schmelze mit einer Zusammensetzung $Bi_{1.2}Pb_{0.7}Sr_{0.7}Ca_{0.5}CuO_x$ auf. Die Variable x nimmt dabei einen Zahlenwert im Bereich von 0 bis 4,7 an. Die gezielte Entmischung zur Erzeugung der pinnenden Materialbestandteile läßt sich durch eine Glühbehandlung der weitgehend phasenreinen Pb2223 Probe über eine Zeitdauer von 1 bis 40 Minuten in einem Sauerstoff enthaltenden Medium im Temperaturbereich zwischen 820 und 900 °C erreichen.

Um diesen Effekt systematisch untersuchen zu können, wurde die Temperaturabhängigkeit der Pb-Löslichkeit untersucht. Die Werte wurden mit Elektronenstrahlmikroanalytik bestimmt.

Tab. 1

| Pb-Löslichkeit im System $(Bi,Pb)_{2+x}(Sr,Ca)_4 Cu_3 O_{10+d}$ | |
| --- | --- |
| Temperatur / °C | Pb-Gehalt / Gew. % |
| 840 | 15,0 |
| 850 | 14,4 |
| 865 | 11,5 |

Die Tab. 1 zeigt, daß der Pb-Gehalt der Pb-2223 Phase mit steigender Temperatur abnimmt.

Wenn die oben beschriebenen Ausscheidungen in einer gepreßten Tablette vorzugsweise bei 865 °C in Luft bei einer Glühdauer von 30 Minuten gebildet werden, tragen diese Proben bei gleichem Magnetfeld überraschenderweise einen bis zu dreifach höheren Strom im Vergleich zur unbehandelten Probe. Mit

2

zunehmender Glühzeit durchschreitet die Pinningkraft ein Maximum. Dieser Sachverhalt wird in Tabelle 2 gezeigt. Hier ist der oben beschriebene Faktor F durch SQUID-Magnetometermessungen bestimmt worden. Die kleinsten Werte für F entsprechen der höchsten Pinning-Kraft. Deutlich ist bei der Glühdauer t = 30 Minuten ein Minimum zu sehen.

Tab. 2

| Quotient aus der Magnetisierung einer Probe bei 500 Gauss und der Magnetisierung der Probe bei 10 000 Gauss bzw. 20 000 Gauss (Faktor F) in Abhängigkeit von der Glühtemperatur. | | |
|---|---|---|
| Glühdauer/min. | F (10 000 Gauss) | F (20 000 Gauss) |
| | | |
| 0 | 122 | 18 |
| 15 | 62 | 13 |
| 30 | 41 | 8 |
| 45 | 52 | 10 |
| 60 | 92 | 16 |

Die zusätzlich bestimmten Suszeptibilitäten der unterschiedlich behandelten Proben zeigen keine signifikante Änderung sowohl hinsichtlich der Sprungtemperatur als auch der supraleitenden Volumenanteile. So liegen nach der Glühbehandlung Proben mit verbesserten elektrischen Kenndaten vor.

Beispiel 1

Es wurde eine Charge mit der chemischen Zusammensetzung $Bi_{1.8}Pb_{0.4}Sr_2Ca_{2.2}Cu_3O_{10+d}$ pulvermetallurgisch hergestellt. Das Pulver wurde bei 750 und 800 °C jeweils 24 Stunden kalziniert. Die so hergestellten Grünlinge wurden nach nochmaligem Homogenisieren bei 840 °C an Luft gesintert. Die Sinterkörper enthalten nach dieser einmaligen Reaktionsglühung circa 90 Vol.-% an Pb2223 Phase und circa 10 Vol.-% $Ca_2CuO_3$-Phase. Diese Werte wurden aus Röntgenpulveraufnahmen bestimmt. Zusätzlich wurden mehrere Sinterkörper dieser selben Charge zur Erzeugung der Pinning-Zentren über verschiedene Zeitintervalle bei 850 und 865 °C an Luft geglüht. Die Proben wurden jeweils nach der Glühung an Luft auf einer Kupferplatte (ca. 10 mm stark) abgeschreckt. Die Abkühlrate liegt im Bereich von 100 K/s für das Temperaturintervall von der Glühtemperatur bis 600 °C und erniedrigt sich auf ca. 10 K/s für das Temperaturintervall von 600 °C bis Raumtemperatur. Die Messung der Hysterese der Magnetisierung der bei 865 °C geglühten Proben bei 30 K zeigen, daß die Magnetisierung der Proben eine Funktion der Glühzeit ist. Die genauen Meßwerte wurden bereits in Tab. 2 wiedergegeben. Aus der Magnetisierung der Proben wurden außerdem die Stromtragfähigkeiten der Proben abgeschätzt. Bei einer Temperatur 30 K und einem Magnetfeld 500 Gauss ergeben sich $10^4$ A/cm$^2$, bei 10 000 Gauss $10^3$ A/cm$^2$ und bei 20 000 Gauss $10^2$ A/cm$^2$.

Beispiel 2

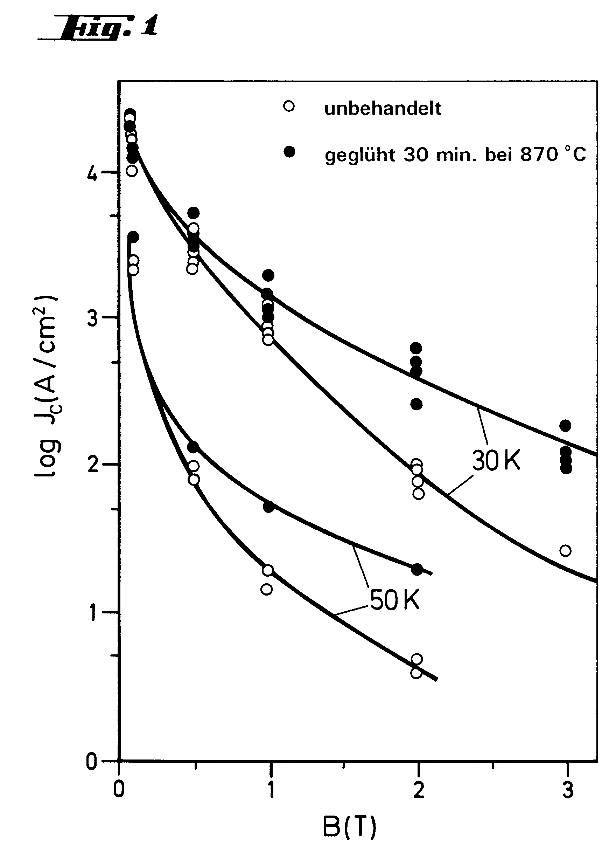

Eine Charge mit derselben nominalen chemischen Zusammensetzung wie in Beispiel 1 wird bis auf die Glühtemperatur 870 °C für die Zeit von 30 Minuten identisch behandelt. In Abb. 1 sind die kritischen Stromdichten ($J_c$) mehrerer Proben (jeder Meßpunkt entspricht einer Probe) in Abhängigkeit vom Magnetfeld wiedergegeben. $J_c$ wurde nach dem Bean-Modell bei 30 und bei 50 K aus den magnetischen Messungen berechnet. Erkennbar ist bei niedrigen Magnetfeldstärken (ca. 500 Gauss) ein nahezu übereinstimmendes $J_c$ von unbehandelter und behandelter Probe. Bei einer Magnetfeldstärke von 2 Tesla und 30 K ist $J_c$ der bei 870 °C geglühten Probe jedoch annähernd eine Größenordnung von einer Zehnerpotenz höher als $J_c$ der unbehandelten Probe. Bei 50 K ist $J_c$ der behandelten Probe bei 500 Gauss bereits um den Faktor 3 höher, während dieses Verhältnis bis zu 2 Tesla auf den Faktor 5 anwächst.

**Patentansprüche**

1. Verfahren zur Erhöhung der Pinningkraft in Bi-Pb-Sr-Ca-Cu-O hochtemperatursupraleitfähigen Keramiken, dadurch gekennzeichnet, daß man die Pb2223 Phase enthaltende Keramik über eine Haltezeit von 1 bis 60 min unter Sauerstoff enthaltender Gasatmosphäre auf eine Temperatur von 825 bis 900 °C erhitzt.

2. Verfahren nach Anspruch 1, dadurch gekennzeichnet, daß man die Temperatur im Bereich von 850 bis 870 °C einstellt.

3. Verfahren nach Anspruch 1 oder 2, dadurch gekennzeichnet, daß man die Haltezeit im Bereich von 20 bis 40 min einstellt.

4. Verfahren nach einem der Ansprüche 1 bis 3, dadurch gekennzeichnet, daß man die nominale Zusammensetzung der Keramik $Bi_vPb_w(Sr,Ca)_xCu_yO_z$ innerhalb folgender Grenzen festlegt:
   $1 \leqq v \leqq 3$;
   $w \leqq 1$;
   $2 \leqq y \leqq 5$;
   $2 \leqq x \leqq 6$, wobei man die Relation Sr/Ca = 2.5/1.5 to 1.5/2.5 einhält; und
   $5.6 \leqq z \leqq 17$.

5. Verfahren nach Anspruch 4, dadurch gekennzeichnet, daß man die Bedingung $1.8 \leqq v \leqq 1.9$ einhält.

6. Verfahren nach Anspruch 4, dadurch gekennzeichnet, daß man die Bedingung $0.3 \leqq w \leqq 0.4$ einhält.

7. Verfahren nach Anspruch 4, dadurch gekennzeichnet, daß man die Bedingung $3.0 \leqq y \leqq 3.1$ einhält.

8. Verfahren nach Anspruch 4, dadurch gekennzeichnet, daß man die Bedingung $0.3 \leqq w \leqq 0.4$ einhält.

9. Verfahren nach Anspruch 4, dadurch gekennzeichnet, daß man die Bedingungen $3.9 \leqq x \leqq 4.3$ und $0.9 \leqq Sr/Ca \leqq 1.0$ einhält.

10. Hoch-$T_c$-supraleitende Pb2223 Phase enthaltende Keramik hergestellt nach einem Verfahren der Ansprüche 1 bis 9, dadurch gekennzeichnet, daß sie eine Stromtragefähigkeit von wenigstens $10^2$ $A/cm^2$ in einem Magnetfeld von 20,000 Gauss besitzt.

Fig. 1

Europäisches
Patentamt

**EUROPÄISCHER RECHERCHENBERICHT**

Nummer der Anmeldung

EP 94 10 9160

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| X,P | WO-A-93 22799 (UNISEARCH LIMITED) * Seite 3, Zeile 17 - Zeile 20; Ansprüche 1-13 * * Seite 6, Zeile 3 - Seite 7, Zeile 32; Beispiel 3 * --- | 1-10 | C04B35/00 H01L39/24 |
| X | EP-A-0 536 730 (INTERNATIONAL SUPERCONDUCTIVITY TECHNOLOGY CENTER) * Seite 4, Zeile 8 - Zeile 23; Ansprüche 1-4; Abbildung 1 * * Seite 6, Zeile 1 - Zeile 34 * --- | 1-10 | |
| A | US-A-5 114 909 (D. SHI) * Spalte 1, Zeile 52 - Zeile 58; Ansprüche 1-6 * * Spalte 2, Zeile 55 - Zeile 68 * * Spalte 3, Zeile 32 - Zeile 42 * --- | 1-10 | |
| A | EP-A-0 450 443 (GENERAL ELECTRIC COMPANY) * Spalte 2, Zeile 36 - Zeile 46; Ansprüche 1-4 * * Spalte 9, Zeile 28 - Zeile 34 * ----- | 1-10 | RECHERCHIERTE SACHGEBIETE (Int.Cl.5) C04B H01L |

Der vorliegende Recherchenbericht wurde für alle Patentansprüche erstellt

| Recherchenort | Abschlußdatum der Recherche | Prüfer |
|---|---|---|
| DEN HAAG | 28. September 1994 | Luethe, H |